# FASCICULE DE BREVET EUROPEEN

(11) **EP 1 446 886 B1**
(45) Date de publication et mention de la délivrance du brevet: **12.04.2006**
(21) Numéro de dépôt: 02785600.4
(22) Date de dépôt: 07.11.2002
(51) Int. Cl.: H03L 7/089, H03D 13/00

(54) **PROCEDE ET DISPOSITIF DE COMPARAISON DE PHASE ET DE FREQUENCE**
VERFAHREN UND VORRICHTUNG ZUM PHASEN- UND FREQUENQUENZVERGLEICH
METHOD AND DEVICE FOR PHASE AND FREQUENCY COMPARISON

(30) Priorité: 19.11.2001 FR 0114946
(43) Date de publication de la demande: 18.08.2004
(73) Titulaire: Stepmind, 92100 Boulogne-Billancourt (FR)
(72) Inventeur: PICHARD, Fabrice, F-14740 Saint Manvieu (FR); CANARD, David, F-14000 Caen (FR)
(74) Mandataire: de Roquemaurel, Bruno
(86) Numéro de dépôt international: PCT/FR2002/003823
(87) Numéro de publication internationale: WO 2003/044960

(56) Documents cités:
- EP-A- 0 316 543
- EP-A- 0 369 858
- FR-A- 2 598 869
- LARSSON P: "REDUCED PULL-IN TIME OF PHASE-LOCKED LOOPS USING A SIMPLE NONLINEARPHASE DETECTOR" IEE PROCEEDINGS: COMMUNICATIONS, INSTITUTION OF ELECTRICAL ENGINEERS, GB, vol. 142, no. 4, 1 août 1995 (1995-08-01), pages 221-226, XP000530221 ISSN: 1350-2425

## Description

La présente invention concerne un procédé et un dispositif de comparaison de phase et de fréquence.

Un tel dispositif est par exemple utilisé dans une boucle à verrouillage de phase PLL (Phase Lock Loop) destinée à commander un oscillateur commandé en tension VCO (Voltage Controlled Oscillator).

Une boucle à verrouillage de phase comprend d'une manière classique un oscillateur commandé en tension dont la sortie est rebouclée sur l'entrée d'un comparateur de phase par l'intermédiaire d'un diviseur de fréquence, le comparateur de phase étant relié à une source de fréquence de référence pour comparer la phase du signal issu de l'oscillateur avec la phase du signal de référence. Le signal de sortie du comparateur de phase est appliqué à une entrée de commande de l'oscillateur par l'intermédiaire d'un filtre passe-bas.

Le document EP 0316543 A décrit un procédé pour asservir la fréquence et la phase d'un signal de sortie d'un oscillateur à l'aide d'un comparateur de phase et de fréquence.

La présente invention s'applique notamment, mais non exclusivement, à la téléphonie mobile, dans laquelle la zone géographique à couvrir est divisée en cellules radio auxquelles est attribué un canal de transmission respectif. Dans ce contexte, les circuits d'émission et de réception des téléphones mobiles comprennent notamment un oscillateur commandé en tension intégré dans une boucle à verrouillage de phase du type décrit ci-avant, dans laquelle la sortie de l'oscillateur est appliquée en entrée du comparateur de phase par l'intermédiaire d'un diviseur de fréquence de rapport N. La boucle à verrouillage de phase à pour fonction de verrouiller la fréquence de sortie de l'oscillateur sur une fréquence du canal de la cellule où est localisé le téléphone mobile, chaque canal correspondant à une valeur respective du rapport N. En outre, pour pouvoir déterminer si le téléphone mobile a changé de cellule ou non, il est nécessaire de scruter périodiquement les canaux des cellules adjacentes, et comparer les intensités respectives des signaux reçus de ces cellules avec les signaux reçus de la cellule en cours. Pour effectuer cette scrutation, la valeur du rapport de division N est modifiée de manière à ce que l'oscillateur se verrouille sur la fréquence déterminée du canal de la cellule adjacente. Une fois qu'un signal est reçu de ce canal, la valeur du rapport N doit à nouveau être modifiée pour que l'oscillateur se verrouille sur la fréquence précédente correspondant au canal de la cellule en cours.
Or le temps nécessaire au verrouillage de l'oscillateur sur la fréquence d'un canal n'est pas négligeable et réduit d'autant le temps disponible durant lequel des informations utiles peuvent être transmises, et donc la bande passante utile. On comprend donc que plus ce temps d'acquisition et de verrouillage de l'oscillateur est faible plus la bande passante disponible pour transmettre des informations est grande.

La présente invention a pour objet un comparateur de phase ou détecteur de phase et de fréquence permettant de réduire le temps d'acquisition et de verrouillage d'un oscillateur dans une boucle à verrouillage de phase, par rapport aux dispositifs de l'art antérieur.

Cet objectif est atteint par la prévision d'un procédé pour asservir la fréquence et la phase du signal de sortie d'un oscillateur muni d'une entrée de commande en fréquence, en fonction de la fréquence et de la phase d'un signal de référence, ce procédé consistant à :
- détecter en permanence dans chacun des signaux de référence et provenant de l'oscillateur des événements représentatifs de la fréquence et de la phase du signal,
- générer un premier signal de commande d'un premier niveau, à la suite de la détection d'un desdits événements dans un premier des signaux de référence et provenant de l'oscillateur,
- générer un second signal de commande du premier niveau, à la suite de la détection d'un desdits événements dans le second des signaux de référence et provenant de l'oscillateur,
- appliquer le signal de commande généré à l'entrée de commande de l'oscillateur, et
- arrêter la génération du premier et du second signal de commande lorsqu'ils sont générés simultanément.

Selon l'invention, les premier et second signaux de commande sont de polarités opposées, le procédé comprenant en outre des étapes consistant à :
- déclencher la génération d'un troisième signal de commande d'un second niveau, à la suite de la détection d'un desdits événements dans le premier des signaux de référence et provenant de l'oscillateur, si le premier signal de commande est généré,
- déclencher la génération d'un quatrième signal de commande du second niveau et de polarité opposée au troisième signal de commande, à la suite de la détection d'un desdits événements dans le second des signaux de référence et provenant de l'oscillateur, si le second signal de commande est généré,
- déterminer le signal de commande à appliquer à l'entrée de commande de l'oscillateur en additionnant tous les signaux de commande générés, et
- arrêter la génération de tous les signaux de commande lorsque le troisième et le quatrième signal de commande sont générés simultanément.

De préférence, la fréquence du signal de sortie de l'oscillateur est divisée par un rapport de division, la détection d'événements dans le signal issu de l'oscillateur étant effectuée dans le signal dont la fréquence est divisée par le rapport de division.

Egalement de préférence, le second niveau de signal de commande est identique au premier niveau de signal de commande.

Alternativement, le second niveau de signal de commande est légèrement supérieur au premier niveau de signal de commande.

Selon une particularité de l'invention, le procédé comprend en outre des étapes consistant à :
- générer un (2i-1)-ième signal de commande d'un i-ième niveau, à la suite de la détection d'un desdits événements dans le premier des signaux de référence et provenant de l'oscillateur, pendant que le (2i-3)-ième signal de commande est généré, i étant un nombre entier supérieur à 2,
- générer un (2i)-ième signal de commande du i-ième niveau et de polarité opposée au (2i-1)-ième signal de commande, à la suite de la détection d'un desdits événements dans le premier des signaux de référence et provenant de l'oscillateur, pendant que le (2i-2)-ième signal de commande est généré,
- arrêter la génération des (2i)-ième, (2i-1)-ième, (2i-2)-ième et (2i-3)-ième signaux de commande lorsque les (2i)-ième, (2i-1)-ième signaux de commande sont générés simultanément.

Avantageusement, le i-ième niveau de signal de commande est identique au (i-1)-ième niveau de signal de commande.

L'invention concerne également un comparateur de phase et de fréquence conçu pour piloter la fréquence du signal de sortie d'un oscillateur muni d'une entrée de commande de fréquence, le comparateur recevant en entrée un signal ayant une fréquence de référence et un signal issu de l'oscillateur, et comprenant :
- des premiers moyens de détection pour détecter en permanence dans chacun des signaux de référence et provenant de l'oscillateur des événements représentatifs de la fréquence et de la phase du signal,
- une première source de signal de commande d'un premier niveau,
- une seconde source de signal de commande ayant le premier niveau et de polarité opposée au signal issu de la première source,
- des premiers moyens de commutation qui à l'état fermé appliquent en sortie du comparateur le signal de commande issu de la première source, à la suite de la détection d'un desdits événements dans un premier des signaux de référence et provenant de l'oscillateur,
- des seconds moyens de commutation qui à l'état fermé appliquent en sortie du comparateur le signal issu de la seconde source, à la suite de la détection d'un desdits événements dans le second des signaux de référence et provenant de l'oscillateur, et
- des premiers moyens de commande pour commander les premiers et seconds moyens de commutation pour les placer à l'état ouvert lorsqu'ils sont simultanément à l'état fermé,
caractérisé en ce qu'il comprend en outre :
- une troisième source de signal de commande d'un second niveau,
- une quatrième source de signal de commande ayant le second niveau et de polarité opposée au signal issu de la troisième source,
- des troisièmes moyens de commutation qui, à l'état fermé et lorsque les premiers moyens de commutation sont à l'état fermé, appliquent en sortie du comparateur le signal de commande issu de la troisième source, à la suite de la détection d'un desdits événements dans le premier des signaux de référence et provenant de l'oscillateur,
- des quatrièmes moyens de commutation qui, à l'état fermé et lorsque les seconds moyens de commutation sont à l'état fermé, appliquent en sortie du comparateur le signal issu de la quatrième source, à la suite de la détection d'un desdits événements dans le second des signaux de référence et provenant de l'oscillateur, le signal de sortie du comparateur ayant un niveau correspondant à la somme des signaux de commande appliqués par les moyens de commutation en sortie du comparateur, et
- des seconds moyens de commande pour commander les premiers à quatrièmes moyens de commutation pour les placer à l'état ouvert lorsque les troisièmes et quatrièmes moyens de commutation sont simultanément à l'état fermé.

Avantageusement, le premier et le second niveau des signaux de commande sont constants.

Selon une particularité de l'invention, le comparateur de phase et de fréquence comprend en outre des seconds moyens de détection pour détecter en permanence dans chacun des signaux de référence et provenant de l'oscillateur des événements représentatifs de la fréquence et de la phase du signal, et des moyens pour activer les seconds moyens de détection uniquement lorsque les premiers ou les seconds moyens de commutation sont à l'état fermé, et pour maintenir les seconds moyens de détection à l'état fermé indépendamment de l'état des premiers moyens de détection.

Avantageusement, le comparateur de phase et de fréquence comprend en outre des moyens pour maintenir actifs les seconds moyens de détection pendant le passage à l'état ouvert des premiers et seconds moyens de commutation.

Selon une autre particularité de l'invention, le comparateur de phase et de fréquence comprend en outre des moyens pour maintenir les premiers et seconds moyens de commande à l'état actif tant que les premiers et seconds et/ou les troisièmes et quatrièmes moyens de commutation ne sont pas passés à l'état ouvert, à la suite du déclenchement des moyens de commande.

Selon encore une autre particularité de l'invention, le comparateur de phase et de fréquence comprend en outre :
- une (2i-1)-ième source de signal de commande d'un i-ième niveau,
- une (2i)-ième source de signal de commande ayant le i-ième niveau et de polarité opposée au signal issu de la (2i-1)-ième source,
- des (2i-1)-ième moyens de commutation qui, à l'état fermé et lorsque les (2i-3)-ième moyens de commutation sont à l'état fermé, appliquent en sortie du comparateur le signal de commande issu de la (2i-1)-ième source, à la suite de la détection d'un desdits événements dans le premier des signaux de référence et provenant de l'oscillateur,
- des (2i)-ième moyens de commutation qui, à l'état fermé et lorsque les (2i-2)-ième moyens de commutation sont à l'état fermé, appliquent en sortie du comparateur le signal issu de la (2i)-ième source, à la suite de la détection d'un desdits événements dans le second des signaux de référence et provenant de l'oscillateur, le signal de sortie du comparateur ayant un niveau correspondant à la somme des signaux de commande appliqués par les moyens de commutation en sortie du comparateur, et
- des moyens pour commander les (2i-3)-ième à (2i)-ième moyens de commutation pour les placer à l'état ouvert lorsque les (2i-1)-ième et (2i)-ième moyens de commutation sont simultanément à l'état fermé.

Un mode de réalisation préféré de l'invention sera décrit ci-après, à titre d'exemple non limitatif, avec référence aux dessins annexés dans lesquels
La figure 1 représente schématiquement une boucle à verrouillage de phase classique ;
La figure 2 illustre sous la forme d'un diagramme temporel en fonction de la fréquence d'émission et de réception, une séquence d'émission et de réception effectuée par un téléphone mobile ;
La figure 3 représente sous la forme d'une courbe d'intensité de courant de commande d'oscillateur en fonction du déphasage, la fonction de transfert d'un comparateur de phase et de fréquence selon l'art antérieur ;
La figure 4 montre sous la forme d'un diagramme d'état et de transition, un automate permettant d'obtenir la fonction de transfert représentée sur la figure 3 ;
La figure 5 représente le schéma électronique d'un circuit de comparateur de phase et de fréquence permettant d'obtenir la fonction de transfert représentée sur la figure 3 ;
La figure 6 montre sous la forme d'un diagramme d'état et de transition un automate d'un autre comparateur de phase et de fréquence selon l'art antérieur ;
La figure 7 montre sous la forme d'une courbe d'intensité de courant de commande d'oscillateur en fonction du déphasage, une fonction de transfert du comparateur de phase et de fréquence représenté sur la figure 6 ;
La figure 8 montre sous la forme d'une courbe d'intensité de courant de commande d'oscillateur en fonction du déphasage, la fonction de transfert du comparateur de phase et de fréquence selon l'invention ;
La figure 9 montre sous la forme d'un diagramme d'état et de transition, un automate permettant d'obtenir la fonction de transfert représentée sur la figure 8 ;
La figure 10 représente le schéma électronique d'un premier exemple de circuit de comparateur de phase et de fréquence selon l'invention ;
Les figures 11 et 12 montrent sous la forme d'une courbe d'intensité de courant de commande d'oscillateur en fonction du déphasage, la fonction de transfert du comparateur de phase et de fréquence représenté sur la figure 10 ;
Les figures 13 et 14 représentent les schémas électroniques de deux autres exemples de circuit de comparateur de phase et de fréquence selon l'invention.

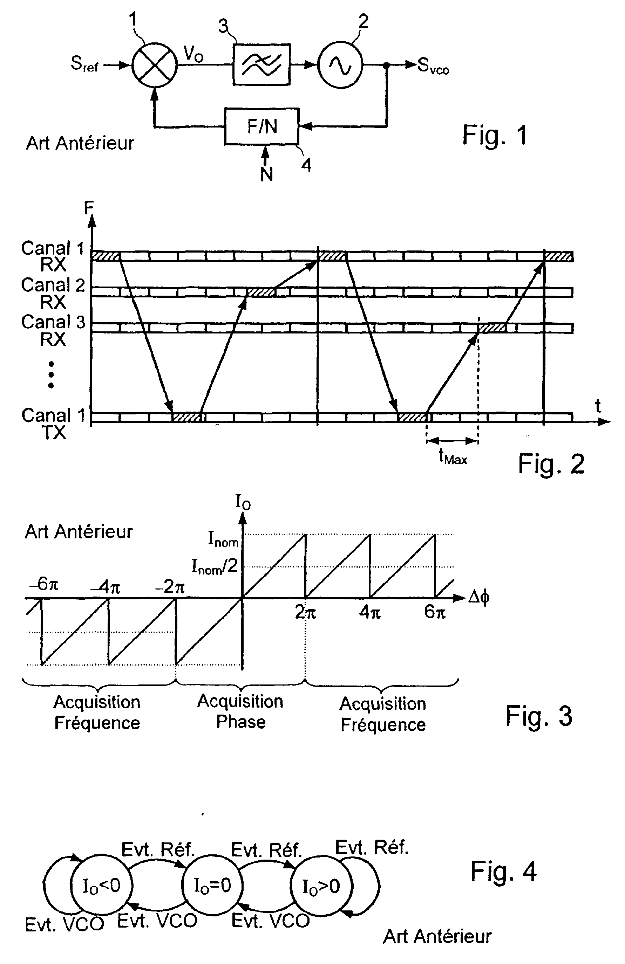

La figure 1 représente une boucle à verrouillage de phase couramment utilisée dans le circuit d'émission/réception d'un téléphone mobile.
Une telle boucle comprend un comparateur de phase et de fréquence 1 auquel est appliqué un signal S_{ref} ayant une fréquence de référence F_{ref} constante, issu par exemple d'un oscillateur à quartz. Le signal de sortie du comparateur 1 est filtré au travers d'un filtre passe-bas 3, puis est appliqué à l'entrée de commande d'un oscillateur commandé en tension VCO 2 qui délivre un signal S_{VCO} dont la fréquence F_{VCO} peut être augmentée ou diminuée en fonction de la tension positive ou négative appliquée sur son entrée de commande. Pour asservir la fréquence F_{VCO} à la fréquence de référence F_{ref}, le signal S_{VCO} est appliqué sur une autre entrée du comparateur de phase et de fréquence 1 qui délivre un signal proportionnel au déphasage mesuré entre les deux signaux appliqués en entrée.

Si l'on souhaite pouvoir faire varier la fréquence F_{VCO} du signal de sortie, la sortie de l'oscillateur 2 est reliée à l'entrée du comparateur 1 par l'intermédiaire d'un diviseur de fréquence 4 de rapport ajustable N, entier ou non entier. Dans ce cas, la fréquence de référence F_{ref} est choisie égale au pas de variation de la fréquence de sortie désirée.

Une telle boucle à verrouillage de phase est par exemple utilisée dans le domaine de la téléphonie mobile. Dans un système de téléphonie mobile, la bande de fréquences attribuée au système est divisée en canaux et la zone géographique couverte par le système est divisée en cellules, chaque cellule disposant d'au moins un canal en émission et un canal en réception, et comprenant au moins une station de base par l'intermédiaire de laquelle les téléphones mobiles situés dans la cellule peuvent communiquer avec le réseau. Chaque téléphone mobile qui se connecte au réseau se voit attribuer une tranche de temps dans une trame périodique en émission et en réception. La figure 2 représente dans un graphe de fréquence en fonction du temps, deux trames de tranches de temps transmises dans différents canaux. Dans ce graphe, les zones hachurées représentent les périodes durant lesquelles un téléphone mobile déterminé est actif en émission ou en réception. Dans l'exemple de cette figure, le téléphone mobile utilise la première tranche de temps du canal 1 RX en réception et la quatrième tranche temporelle du canal 1 TX en émission. A chaque passage entre un mode d'émission et un mode de réception, l'oscillateur local du téléphone mobile doit se verrouiller sur la fréquence du canal correspondant. De même, pour pouvoir déterminer si le téléphone mobile doit changer de cellule en fonction de sa position par rapport aux stations de base, il doit scruter les canaux de réception des cellules voisines, soit dans l'exemple de la figure 2, le canal 2 RX et le canal 3 RX. A cet effet, l'oscillateur local doit également être commandé pour se verrouiller sur la fréquence de ces deux canaux. Ainsi, au cours d'une trame, le téléphone mobile effectue une séquence de réception sur un canal, une séquence d'émission sur un second canal, et une séquence de scrutation d'un troisième canal. Trois changements de fréquence (indiqués par les flèches sur la figure) doivent donc être effectués par trame. Il est à noter que les émissions sont effectuées légèrement en avance par rapport à la quatrième tranche de temps, pour que la station de base reçoive effectivement les données à émettre durant cette tranche de temps.
Il apparaît donc que la somme des temps durant lesquels le téléphone est actif en émission et en réception (zones hachurées) et des temps nécessaires pour effectuer ces sauts de fréquence, doit être inférieure à la durée d'une trame.
Par conséquent, pour ne pas affecter le débit de transmission utile, ces sauts de fréquence doivent être effectués rapidement, ce qui implique que la boucle à verrouillage de phase doit verrouiller rapidement l'oscillateur sur la fréquence du canal à atteindre, à la suite d'un changement du rapport de division N.

Par ailleurs, la durée nécessaire pour effectuer ces sauts de fréquence doit être réduite si l'on souhaite augmenter la bande passante utile du système de téléphonie mobile.

Les comparateurs de phase et de fréquence couramment utilisés dans ce domaine présentent une fonction de transfert telle que celle illustrée sur la figure 3. Cette fonction de transfert comprend trois zones, à savoir un domaine d'acquisition de phase lorsque le déphasage Δφ mesuré par le comparateur est situé entre -2π et +2π, et deux zones d'acquisition de fréquence, lorsque ce déphasage est inférieur à -2π, et respectivement supérieur à 2π. Par ailleurs, dans chaque intervalle situé entre 2nπ et 2(n+1)π, n étant un nombre entier positif, négatif ou nul, le courant I_{O} en sortie du comparateur est proportionnel au déphasage Δφ mesuré par le comparateur. En particulier, cette linéarité de variation du courant I_{O} en fonction du déphasage se retrouve dans tout le domaine d'acquisition de phase.

Cette fonction de transfert peut être obtenue à l'aide d'un automate tel que représenté sur la figure 4. Cet automate comprend trois états, à savoir un état correspondant à un courant de commande I_{O} nul dans lequel l'oscillateur 2 est verrouillé sur la fréquence de consigne égale à N fois la fréquence de référence F_{ref}, un état dans lequel le courant de commande I_{O} est négatif, correspondant à un déphasage négatif, et un état dans lequel le courant de commande I_{O} est positif, correspondant à un déphasage positif. Les changements d'état sont provoqués par la détection d'un événement sur l'un ou l'autre des signaux F_{ref} et F_{VCO} appliqués en entrée du comparateur 1. Dans le cas de signaux binaires, un tel événement est par exemple constitué par un flanc montant détecté dans l'un ou l'autre des signaux d'entrée. Tant qu'un événement apparaît dans le signal de référence, on change d'état vers la droite sur la figure, jusqu'à atteindre l'état dans lequel I_{O} est positif. Inversement, tant qu'un événement apparaît dans le signal issu de l'oscillateur, on change d'état vers la gauche sur la figure, jusqu'à atteindre l'état dans lequel I_{O} est négatif.

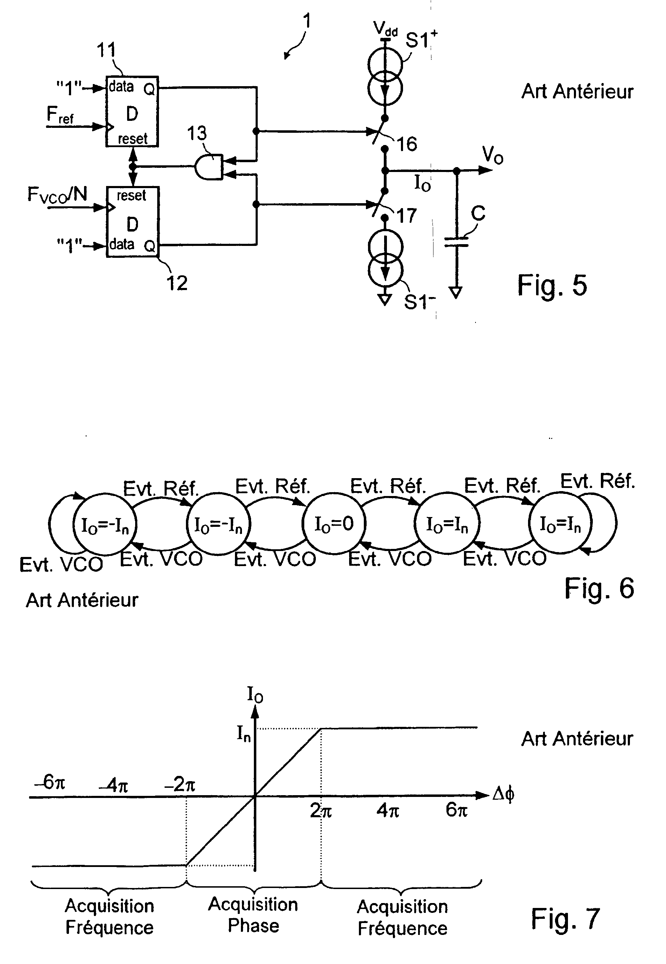

Cet automate peut être réalisé à l'aide du circuit représenté sur la figure 5. Pour plus de détails, on peut se reporter aux documents suivants :
[1] "Monolithic Phase-Locked Loops and Clock Recovery Circuits - A Tutorial", Behzad Razavi, Preface of "Monolithic Phase-Locked Loops and Clock Recovery Circuits, Theory and Design", IEEE PRESS, ISBN 0-7803-1149-3 ;
[2] "A 3-State Phase Detector Can Improve Your Next PLL Design", C. Andrew Sharpe, Electronic Design News Magazine, September 20, 1976.

Ce circuit comprend deux bascules D 11, 12, comprenant chacune une entrée de signal d'horloge respective, une entrée de donnée, une sortie Q et une entrée Reset de commande de remise à zéro. Une telle bascule délivre sur sa sortie Q un signal égal à celui de l'entrée de donnée, à la suite d'une impulsion sur l'entrée du signal d'horloge. Les bascules 11, 12 reçoivent sur leur entrée respective de signal d'horloge, les signaux respectivement aux fréquences de référence F_{ref} et Fvco divisée par N, l'entrée de donnée de ces deux bascules étant forcée à 1. Les sorties Q respectives des deux bascules 11, 12 sont connectées respectivement aux deux entrées d'une porte ET 13 dont la sortie est connectée aux entrées de commande de remise à zéro des deux bascules.
En outre, le signal de sortie Q de la bascule 11 commande un premier interrupteur 16 connecté d'un côté à une borne d'une première source de courant S1⁺ dont l'autre borne est connectée à la source d'alimentation du circuit V_{dd}. Le signal de sortie Q de la bascule 12 commande un second interrupteur 17 connecté à une borne d'une seconde source de courant S1⁻ dont l'autre borne est connectée à la masse, ces deux sources de courant délivrant un courant d'intensité Iₙ identique et dans le même sens, de la source de tension V_{dd} à la masse. Le noeud de jonction des deux interrupteurs 16, 17 est connecté à la sortie du comparateur 1 qui délivre un courant I_{O} de commande de l'oscillateur 2 égal à la différence des courants délivrés par les sources de courant S1⁺ et S1⁻, ce courant étant transformé en une tension de commande V_{O}, par un condensateur C monté en parallèle entre le noeud de jonction des interrupteurs 16, 17 et la masse. La valeur du courant Iₙ est déterminée par les caractéristiques de l'oscillateur 2, du filtre 3 et du diviseur de fréquence 4.
Dans ce montage, les sources de courant sont également appelées "pompes de charge" car elles chargent ou déchargent le condensateur C.

A l'état initial, les deux bascules 11, 12 sont à l'état bas. Par conséquent les deux interrupteurs 16, 17 sont ouverts, et donc le courant de commande I_{O} est nul.
Si à partir de cet état initial, un flanc montant apparaît dans un premier des deux signaux d'entrée aux fréquences respectives F_{ref} et F_{VCO}/N, la bascule 11, 12 correspondante passe à l'état haut, c'est-à-dire que sa sortie Q passe de 0 à 1. Il en résulte que l'interrupteur 16, 17 correspondant se ferme, la source de courant 16, 17 associée délivre un courant Iₙ qui injecte ou retire une charge positive ou négative dans le condensateur C. On se trouve alors dans l'état correspondant à I_{O} positif ou négatif dans l'automate représenté sur la figure 4.

Si un flanc montant apparaît dans le second des deux signaux d'entrée du comparateur 2, l'autre bascule 11, 12 passe également à l'état haut et délivre un signal Q qui passe du niveau 0 à 1, ce qui ferme l'autre interrupteur 16, 17. Il en résulte que la sortie de la porte ET 13 passe du niveau 0 à 1, ce qui déclenche la remise à zéro des deux bascules 11, 12 et donc l'ouverture des deux interrupteurs. Le courant de sortie I_{O} devient alors nul.

On comprend donc que le verrouillage de l'oscillateur 2 est atteint lorsque les flancs montants des deux signaux arrivent en même temps en entrée des bascules 11, 12, provoquant la fermeture et l'ouverture quasi simultanées des deux interrupteurs 16, 17.

Durant les phases d'acquisition de fréquence, le courant de commande moyen est égal à Iₙ/2 en valeur absolue.
Il s'avère qu'un tel circuit qui répond aux besoins actuels des réseaux de téléphonie mobile, ne permet pas d'atteindre des temps d'acquisition et de verrouillage conformes aux nouvelles normes de téléphonie mobile à haut débit, telles que UMTS (Universal Mobile Telecommunication System) ou IMT-2000 (International Telecommunication 2000).

Il existe également des comparateurs dont le fonctionnement est modélisé par un automate à 5 états tel que celui représenté sur la figure 6. Sur cette figure, l'automate comprend cinq états reliés les uns aux autres de manière à former une chaîne, à savoir un état central dans lequel le courant de commande I_{O} est nul, deux états situés à gauche de l'état central, dans lesquels le courant de commande I_{O} est négatif, et deux états situés à droite de l'état central, dans lesquels le courant de commande I_{O} est positif.
Dans cet automate, on se déplace d'un état à l'autre de gauche à droite à chaque fois qu'un événement est détecté dans le signal de référence, et en sens contraire à chaque fois qu'un événement est détecté dans le signal issu de l'oscillateur 2, et dont la fréquence est divisée par le rapport de division N.
Cet automate permet de prendre en compte l'arrivée d'au moins deux événements dans l'un des deux signaux d'entrée entre deux événements consécutifs détectés dans l'autre signal d'entrée (passage dans les états situés aux extrémités de la chaîne d'états de l'automate).

La fonction de transfert d'un tel automate est représentée sur la figure 7. Cette fonction de transfert comprend également trois zones de déphasage, à savoir une zone d'acquisition de phase, lorsque le déphasage Δφ mesuré par le comparateur 1 est situé entre -2π et +2π, la fonction de transfert dans cette zone étant identique à celle représentée sur la figure 3, et deux zones d'acquisition de fréquence, lorsque ce déphasage est inférieur à -2π, et respectivement supérieur à 2π. Dans ces deux dernières zones le courant de commande I_{O} délivré est constant et égal à respectivement +Iₙ et -Iₙ. Par rapport au circuit comparateur à trois états décrit précédemment, le comparateur à cinq états présente l'avantage de présenter un courant moyen de commande, durant les phases d'acquisition de fréquence, égal à Iₙ en valeur absolue, soit le double de celui du comparateur à trois états. Il en résulte une vitesse d'acquisition de fréquence sensiblement doublée par rapport au comparateur à trois états.

Il s'avère qu'un tel comparateur n'offre pas des performances suffisantes pour répondre aux besoins spécifiés par les nouvelles normes des réseaux de téléphonie mobile.

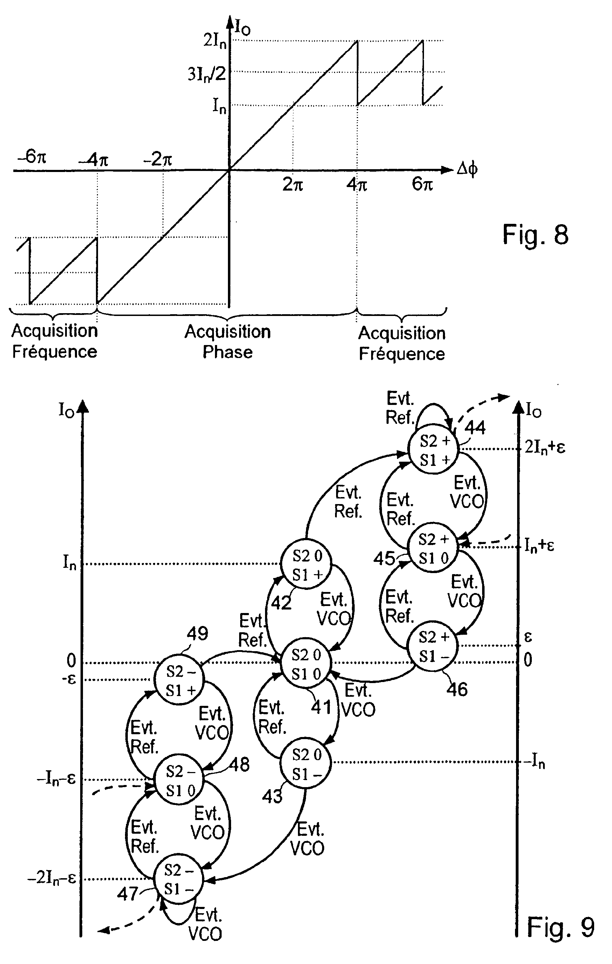

Pour répondre à ces nouveaux besoins, la présente invention a pour objet un comparateur de phase et de fréquence du type décrit ci-avant dans lequel la zone d'acquisition de phase est étendue et la valeur du courant moyen de commande I_{O} dans la zone d'acquisition de fréquence est augmentée, comme cela est illustré par la fonction de transfert représentée sur la figure 8. Sur cette figure, la zone d'acquisition de phase (zone où le courant de commande I_{O} est proportionnel au déphasage Δφ) correspond à des déphasages compris entre -4π et +4π, et le courant moyen de commande I_{O} dans les zones d'acquisition de fréquence est égal à 3Iₙ/2 en valeur absolue, c'est-à-dire compris entre Iₙ et 2Iₙ.

Cet objectif est atteint à l'aide de l'automate à neuf états représenté sur la figure 9. Les axes verticaux montrés sur cette figure représentent les valeurs du courant de commande I_{O} obtenu en sortie du comparateur 1, les différents états de l'automate étant positionnés par rapport à ces axes en fonction du courant de commande I_{O} correspondant généré par le comparateur.

Dans l'état initial 41, l'automate ne délivre aucun courant de commande I_{O}. A partir de cet état initial, si un événement se produit dans un premier des signaux d'entrée respectivement à la fréquence de référence F_{ref} et F_{VCO}/N, l'automate passe dans un état 42, respectivement 43 dans lequel le courant délivré est respectivement égal à Iₙ et -Iₙ. Si dans l'état 42 ou 43, un événement se produit dans le second signal, on revient à l'état initial 41. Par contre, si dans l'état 42 ou 43, un événement se produit dans le premier signal, l'automate passe à l'état 44, respectivement 47 dans lequel le courant généré est égal à 2Iₙ+ε, respectivement -2Iₙ-ε, et reste dans cet état tant qu'un événement n'est pas apparu dans le second signal. Lorsqu'un événement apparaît dans le second signal, l'automate passe alors de l'état 44, respectivement 47, à l'état 45, respectivement 48, dans lequel le courant de commande est égal à Iₙ+ε, respectivement -Iₙ-ε.

Si dans l'état 45 ou 48, un événement survient alors dans le premier signal, l'automate revient à l'état 44, respectivement 47. Si au contraire, un événement survient dans le second signal, l'automate passe à l'état 46, respectivement 49, dans lequel le courant de commande I_{O} est égal à ε, respectivement -ε.

Dans l'état 46, 49, l'automate revient à l'état 45, respectivement 48 si un événement apparaît dans le premier signal, et à l'état initial 41 si un événement apparaît dans le second signal.

Par conséquent, l'état 44 ou 47 est atteint lorsque deux événements dans un premier des deux signaux d'entrée du comparateur, sont détectés entre deux événements consécutifs dans le second des signaux d'entrée.

On peut remarquer que cet automate qui comprend trois séries de trois états, peut être étendu à un automate à cinq séries de trois états (comme suggéré par les flèches en traits interrompus), dans lequel les deux séries de trois états, supplémentaires comprennent des états dans lesquels le courant de commande I_{O} est respectivement égal à 3Iₙ+ε+ε₁, 2Iₙ+ε+ε₁ et Iₙ+ε+ε₁ pour la première série et -3Iₙ-ε-ε₁, -2Iₙ-ε-ε₁, -Iₙ-ε-ε₁, pour la seconde série.
La valeur de ε₁ peut avantageusement être choisie égale à 0.

L'automate à 15 états peut être généralisé pour obtenir un automate à 3(2n+1) états (n étant un entier supérieur à 2).

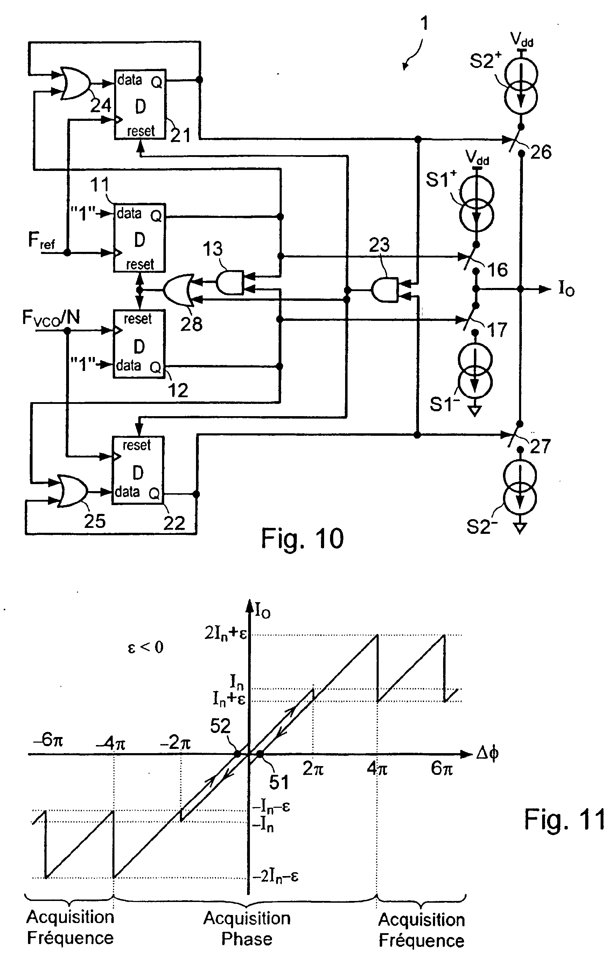

L'automate représenté sur la figure 9 est par exemple réalisé à l'aide du circuit représenté sur la figure 10. Ce circuit est construit à partir du circuit représenté sur la figure 5 dont il reprend les mêmes composants interconnectés de la même manière. Pour la description de ces composants qui sont repérés dans la figure 10 par les mêmes numéros de référence, on se reportera donc à la figure 5.

En plus du circuit représenté sur la figure 5, le circuit représenté sur la figure 10 comprend un autre circuit sensiblement identique à celui de la figure 5, c'est-à-dire deux bascules D 21, 22 dont les sorties Q respectives commandent deux interrupteurs 26, 27. Ces interrupteurs 26, 27 commandent l'activation de deux sources de courant S2⁺ et S2⁻ qui sont connectées à la source d'alimentation du circuit V_{dd}, à la masse et à la sortie en courant I_{O} du circuit de la même manière que les sources S1⁺ et S1⁻, pour délivrer sur cette sortie un courant Iₙ+ε, respectivement -Iₙ-ε.

Les entrées de signal d'horloge des bascules 21, 22 reçoivent respectivement le signal à la fréquence de référence et le signal à la fréquence de l'oscillateur divisé par N F_{VCO}/N. Par ailleurs, les sorties Q de ces deux bascules 21, 22 sont connectées aux entrées respectives d'une porte ET 23 dont la sortie est connectée aux entrées de commande de remise à zéro Reset des deux bascules 21,22.
En outre, les entrées de données des deux bascules 21, 22 sont connectées respectivement à la sortie de deux portes OU 24, 25, les entrées de la porte OU 24 connectée à l'entrée de la bascule 21 étant connectées aux sorties respectives des bascules 11 et 21, et les entrées de la porte OU 25 connectée à l'entrée de la bascule 22 étant connectées aux sorties respectives des bascules 12 et 22.
Par conséquent, l'une ou l'autre des bascules 21, 22 ne peut passer à l'état haut tant que la bascule 11, 12 reliée à la même entrée du comparateur n'est pas passée à l'état haut, et cet état haut de l'une ou l'autre des bascules 21, 22 est maintenu indépendamment de l'état de la bascule 11, 12 correspondante, jusqu'à ce qu'un signal à l'état haut soit appliqué sur l'entrée de commande de remise à zéro de la bascule 21, 22.

Ce circuit comprend également une autre porte OU 28 qui est disposée entre la sortie de la porte ET 13 et les entrées de remise à zéro des bascules 11, 12. L'autre entrée de la porte OU 28 étant connectée à la sortie de la porte ET 23.
De cette manière, une remise à zéro des bascules 21, 22 entraîne la remise à zéro des bascules 11, 12.

Comme indiqué sur la figure 9, dans l'état 41, toutes les sources de courant sont inactives (interrupteurs 16, 17, 26, 27 à l'état ouvert). Dans l'état 42, respectivement 43, seule la source S1⁺, respectivement S1⁻, est active. Dans l'état 44, respectivement 47, les sources S1⁺ et S2⁺, respectivement S1⁻ et S2⁻, sont actives. Dans l'état 45, respectivement 48, seule la source S2⁺, respectivement S2⁻, est active. Dans l'état 46, respectivement 49, les sources S2⁺ et S1⁻, respectivement S2⁻ et S1⁺, sont actives.

Tant que le signal de référence et le signal issu du diviseur de fréquence 4 ont la même fréquence (le déphase Δφ mesuré par le comparateur 1 est situé entre -2π et +2π), le fonctionnement du circuit est identique à celui représenté sur la figure 5, c'est-à-dire que les sources de courant S2⁻ et S2⁺ ne sont jamais activées. L'automate reste alors dans les états 41 à 43.

Par contre, dès que dans un premier des deux signaux d'entrée du comparateur 1, deux flancs montants apparaissent entre deux flancs montants consécutifs du second signal d'entrée, la bascule 21 ou 22 correspondante passe à l'état 1, activant la source de courant S2⁻ ou S2⁺ commandée par la bascule qui passe à l'état 1, la source S1⁻, respectivement S1⁺ ayant été activée par la bascule 12 ou respectivement 11 qui est passée à l'état 1 au premier des deux flancs montants. Le déphasage Δφ se trouve alors supérieur +2π ou inférieur à -2π. L'automate se trouve alors dans l'état 44 ou 47.
Si un flanc montant apparaît alors sur le second signal, la porte ET 13 remet à l'état 0 les deux bascules 11, 12, ce qui désactive la source de courant S1⁻, respectivement S1⁺ (états 45 ou 48). Seule la source S2⁻, respectivement S2⁺ est donc active et le reste tant que deux flancs montants sur le second signal ne sont pas détectés entre deux flancs montants consécutifs du premier signal.
Ces dispositions permettent d'obtenir la zone linéaire de courant de commande en fonction du déphasage, située entre -4π et +4π (figure 8).

Si dans le second signal d'entrée, deux flancs montants apparaissent entre deux flancs montants consécutifs du premier signal d'entrée, la bascule 11, 12 correspondante change d'état, ce qui active la source de tension S1⁺, S1⁻, de sorte que les sources S2⁺ et S1⁻ ou S2⁻ et S1⁺ sont actives simultanément (états 46 ou 49). Le courant de commande I_{O} devient alors égal à ε ou -ε.

Pour atteindre l'état initial 41 lorsque l'une des sources S2⁻ ou S2⁺ est active, le comparateur 1 doit recevoir entre deux flancs montants consécutifs dans le premier signal, soit deux flancs montants dans le second signal (à partir de l'état 45 ou 48), soit trois flancs montants dans le second signal (à partir de l'état 44 ou 47).
Lorsqu'un tel événement se produit, la bascule 21, 22 qui était à l'état bas, passe à l'état haut, ce qui fait passer la sortie de porte ET 23 à l'état haut, et donc déclenche la remise à zéro des bascules 21, 22. Comme le signal de sortie de la porte ET 23 est appliqué à l'entrée de la porte OU 28, les bascules 11 et 12 sont également remises à zéro.

Il est en effet nécessaire de remettre à zéro des bascules 11, 12 lors de la mise à zéro des bascules 21, 22, car sinon, le circuit passerait directement à l'état 43 ou 42.

Les sources de courant S1⁺ et S2⁺, respectivement S1⁻ et S2⁻, sont avantageusement choisies de manière à délivrer des courants légèrement différents (ε non nul) de manière à éviter que l'automate présente trois états, à savoir 41, 46 et 49, dans lesquels le courant de commande I_{O} est voisin de zéro. En outre, le courant délivré par les sources S2⁻ et S2⁺ doit être légèrement supérieur au courant délivré par les sources S1⁻ et S1⁺ (ε positif) pour éviter d'atteindre un état dans lequel le courant de commande I_{O} est nul tandis que le déphasage Δφ n'est pas nul, comme cela est illustré sur la figure 11.
En effet, la fonction de transfert représentée sur la figure 11, qui est obtenue lorsque ε est négatif, fait apparaître deux points singuliers 51 et 52 qui sont atteints, en allant vers le point de verrouillage (Δφ = 0, I_{O} = 0), sans que le déphasage soit nul, avec deux sources de courant actives, à savoir S1⁻ et S2⁺ ou S2⁻ et S1⁺. Il en résulte que l'oscillateur 2 est verrouillé avec deux sources de courant actives qui se compensent en moyenne. Il s'avère qu'un tel état est à éviter étant donné que chaque source de courant constitue une source de bruit qui est alors appliquée à l'entrée de commande de l'oscillateur. Il est donc préférable qu'à l'état verrouillé de l'oscillateur, toutes les sources de courant soient inactives.

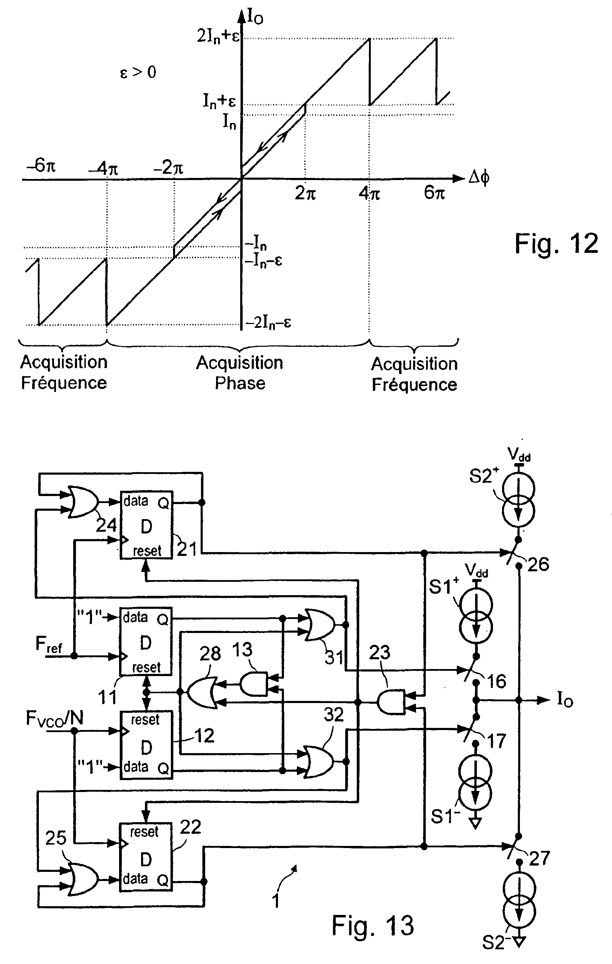

Au contraire, lorsque ε est positif, comme illustré sur la figure 12, le circuit n'atteint jamais un état dans lequel le déphasage Δφ est non nul tandis que le courant de commande I_{O} est nul, mais au contraire des états dans lesquels le déphasage Δφ est nul et le courant de commande I_{O} est non nul. En outre, cette disposition permet d'augmenter la valeur absolue du courant moyen de commande durant les phases d'acquisition de fréquence qui est alors égal à Iₙ+ε/2 au lieu de Iₙ, ce paramètre ayant une influence importante sur l'efficacité du comparateur 1.

Selon un second mode de réalisation de l'invention, le comparateur 1 représenté sur la figure 13 comprend deux portes OU 31, 32 supplémentaires, par rapport au comparateur représenté sur la figure 10. La porte OU 31 est disposée sur la liaison entre la sortie Q de la bascule 11 et le point de jonction entre l'entrée de commande de l'interrupteur 16 et l'entrée de la porte OU 24, de manière à recevoir en entrée le signal issu de la sortie Q de la bascule 11. L'autre entrée de la porte OU 31 est connectée aux entrées de commande de remise à zéro des bascules 11, 12.
De manière analogue, la porte OU 32 est disposée sur la liaison entre la sortie Q de la bascule 12 et le point de jonction entre l'entrée de commande de l'interrupteur 17 et l'entrée de la porte OU 25, de manière à recevoir en entrée le signal issu de la sortie Q de la bascule 12. L'autre entrée de la porte OU 32 est connectée aux entrées de commande de remise à zéro des bascules 11, 12.

Cette disposition permet de s'affranchir d'éventuelles différences de temps de propagation des signaux dans les différentes parties du circuit, en maintenant au niveau 1 les entrées de données respectives des bascules 21, 22 pendant la remise à zéro des bascules 11, 12.
En particulier, cette disposition permet d'éviter la situation critique dans laquelle un flanc montant sur un premier signal d'entrée du comparateur arrive juste avant un second flanc montant consécutif sur le second signal d'entrée, la source S2⁻ ou S2⁺ étant sur le point d'être activée. Comme un flanc montant dans le premier signal arrive avant le flanc montant d'activation de la source S2⁻ ou S2⁺, la source S1⁻ respectivement S1⁺ étant active, les deux bascules 11, 12 sont remises à zéro. Le flanc montant qui arrive sur le second signal durant la remise à zéro des deux bascules 11, 12 n'est pas détecté. Il en résulte que la source de courant S2⁻ ou S2⁺ correspondante n'est pas activée, et que le second signal est considéré en retard par rapport au premier de 2π. Ce mode de fonctionnement correspond à celui qui est illustré par la fonction de transfert de l'art antérieur, représentée sur la figure 3.

Au contraire, l'ajout des portes OU 31, 32 permet de maintenir à 1 les entrées de données respectives des portes 21 et 22, lesquelles peuvent alors changer d'état et activer la source S2⁻ ou S2⁺ correspondante si un flanc montant survient pendant la remise à zéro des bascules 11, 12.

En outre, comme les sources S1⁻ et S1⁺ sont pilotées par l'addition logique du signal de sortie des bascules 11, 12 et du signal de remise à zéro de celles-ci, cette disposition permet également de garantir l'activation complète des sources S1⁻ et S1⁺.

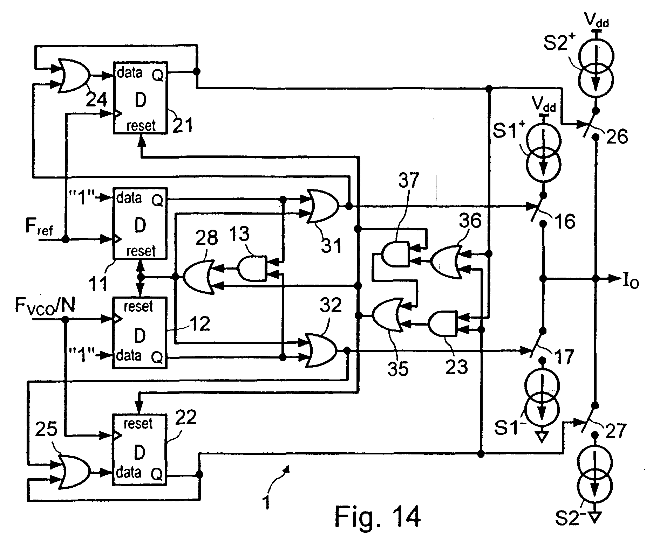

Selon un troisième mode de réalisation de l'invention, le comparateur 1 représenté sur la figure 14 comprend en outre, par rapport au comparateur représenté sur la figure 13, deux portes OU 35, 36, et une porte ET 37 supplémentaires.
La porte OU 36 est connectée au circuit de manière à recevoir en entrée les signaux de sortie des bascules 21, 22. La sortie de la porte OU 36 est connectée à une entrée de la porte ET 37 dont l'autre entrée est reliée à l'entrée de commande de remise à zéro des deux bascules 21, 22. Par ailleurs, la porte OU 35 est interposée entre la sortie de la porte ET 23 et la ligne de commande de remise à zéro des bascules 21, 22, l'autre entrée de la porte OU 35 étant reliée à la sortie de la porte ET 37.

Cette disposition permet également de s'affranchir de différences de temps de propagation dans les différentes parties du circuit, qui peuvent survenir en particulier au niveau de la désactivation des deux sources S2⁻ et S2⁺.
En effet, si tel n'est pas le cas, le signal de remise à zéro des bascules 21, 22 peut passer à 0 avant que l'une des deux sources S2⁻ et S2⁺ soit désactivée. Les trois portes 35, 36, 37 permettent de maintenir le signal de remise à zéro jusqu'à ce que les deux sources soient désactivées, en maintenant le signal de commande de remise à zéro à l'état actif tant que l'une ou l'autre des deux sources S2⁻ et S2⁺ n'est pas désactivée.

Bien entendu, on peut appliquer cette disposition également sur le circuit de remise à zéro des bascules 11, 12.

Comme précédemment mentionné en référence à la figure 9, le comparateur représenté sur les figures 10, 13 et 14 qui comprend deux étages sensiblement identiques au circuit de la figure 5, peut être généralisé à un comparateur à n étages, dans lequel les bascules de l'étage i ne peuvent passer à l'état 1 que si la bascule de l'étage inférieur i-1, connectée à la même entrée du comparateur est déjà passée à l'état 1, et dans lequel la remise à zéro des bascules de l'étage i déclenche la remise à zéro des bascules de l'étage inférieur i-1, i étant un nombre entier compris entre 2 et n.

## Revendications

1. Procédé pour asservir la fréquence et la phase (F_{VCO}) du signal de sortie d'un oscillateur (2) muni d'une entrée de commande en fréquence, en fonction de la fréquence (F_{ref}) et de la phase d'un signal de référence (S_{ref}), ce procédé consistant à :
- détecter en permanence dans chacun des signaux de référence (S_{ref}) et provenant de l'oscillateur des événements représentatifs de la fréquence et de la phase du signal,
- générer un premier signal de commande d'un premier niveau (Iₙ), à la suite de la détection d'un desdits événements dans un premier des signaux de référence et provenant de l'oscillateur,
- générer un second signal de commande du premier niveau à la suite de la détection d'un desdits événements dans le second des signaux de référence et provenant de l'oscillateur,
- appliquer le signal de commande (I_{O} ; V_{O}) généré à l'entrée de commande de l'oscillateur, et
- arrêter la génération du premier et du second signal de commande lorsqu'ils sont générés simultanément,
**caractérisé en ce que** les premier et second signaux de commande sont de polarités opposées, le procédé comprenant en outre des étapes consistant à :
- déclencher la génération d'un troisième signal de commande d'un second niveau (Iₙ+ε), à la suite de la détection d'un desdits événements dans le premier des signaux de référence (S_{ref}) et provenant de l'oscillateur (2), si le premier signal de commande est généré,
- déclencher la génération d'un quatrième signal de commande du second niveau et de polarité opposée au troisième signal de commande, à la suite de la détection d'un desdits événements dans le second des signaux de référence et provenant de l'oscillateur, si le second signal de commande est généré,
- déterminer le signal de commande (I_{O} ; V_{O}) à appliquer à l'entrée de commande de l'oscillateur (2) en additionnant tous les signaux de commande générés, et
- arrêter la génération de tous les signaux de commande lorsque le troisième et le quatrième signal de commande sont générés simultanément.

2. Procédé selon la revendication 1,
**caractérisé en ce que** la fréquence (F_{VCO}) du signal de sortie de l'oscillateur (2) est divisée par un rapport de division (N), la détection d'événements dans le signal issu de l'oscillateur étant effectuée dans le signal dont la fréquence (F_{VCO}) est divisée par le rapport de division (N).

3. Procédé selon la revendication 1 ou 2,
**caractérisé en ce que** le second niveau (Iₙ+ε) de signal de commande est identique au premier niveau (Iₙ) de signal de commande.

4. Procédé selon la revendication 1 ou 2,
**caractérisé en ce que** le second niveau (Iₙ+ε) de signal de commande est légèrement supérieur au premier niveau (Iₙ) de signal de commande.

5. Procédé selon l'une des revendications 1 à 4,
**caractérisé en ce qu'**il comprend en outre des étapes consistant à :
- générer un (2i-1)-ième signal de commande d'un i-ième niveau, à la suite de la détection d'un desdits événements dans le premier des signaux de référence et provenant de l'oscillateur (2), pendant que le (2i-3)-ième signal de commande est généré, i étant un nombre entier supérieur à 2,
- générer un (2i)-ième signal de commande du i-ième niveau et de polarité opposée au (2i-1)-ième signal de commande, à la suite de la détection d'un desdits événements dans le premier des signaux de référence et provenant de l'oscillateur, pendant que le (2i-2)-ième signal de commande est généré,
- arrêter la génération des (2i)-ième, (2i-1)-ième, (2i-2)-ième et (2i-3)-ième signaux de commande lorsque les (2i)-ième, (2i-1)-ième signaux de commande sont générés simultanément.

6. Procédé selon la revendication 5,
**caractérisé en ce que** le i-ième niveau de signal de commande est identique au (i-1)-ième niveau de signal de commande.

7. Comparateur de phase et de fréquence conçu pour piloter la fréquence du signal de sortie d'un oscillateur (2) muni d'une entrée de commande de fréquence, le comparateur recevant en entrée un signal (S_{ref}) ayant une fréquence de référence (F_{ref}) et un signal issu de l'oscillateur, et comprenant :
- des premiers moyens de détection (11, 12) pour détecter en permanence dans chacun des signaux de référence (S_{ref}) et provenant de l'oscillateur des événements représentatifs de la fréquence et de la phase du signal,
- une première source (S1⁺) de signal de commande d'un premier niveau (Iₙ),
- une seconde source (S1⁻) de signal de commande ayant le premier niveau (Iₙ) et de polarité opposée au signal issu de la première source,
- des premiers moyens de commutation (11, 16) qui à l'état fermé appliquent en sortie du comparateur (1) le signal de commande issu de la première source (S1⁺), à la suite de la détection d'un desdits événements dans un premier des signaux de référence et provenant de l'oscillateur,
- des seconds moyens de commutation (12, 17) qui à l'état fermé appliquent en sortie du comparateur (1) le signal issu de la seconde source (S1⁻), à la suite de la détection d'un desdits événements dans le second des signaux de référence et provenant de l'oscillateur, et
- des premiers moyens de commande (13) pour commander les premiers et seconds moyens de commutation pour les placer à l'état ouvert lorsqu'ils sont simultanément à l'état fermé,
**caractérisé en ce qu'**il comprend en outre :
- une troisième source (S2⁺) de signal de commande d'un second niveau (Iₙ+ε),
- une quatrième source (S2⁻) de signal de commande ayant le second niveau (Iₙ+ε) et de polarité opposée au signal issu de la troisième source,
- des troisièmes moyens de commutation (21, 26) qui, à l'état fermé et lorsque les premiers moyens de commutation (11, 16) sont à l'état fermé, appliquent en sortie du comparateur (1) le signal de commande issu de la troisième source (S2⁺), à la suite de la détection d'un desdits événements dans le premier des signaux de référence et provenant de l'oscillateur,
- des quatrièmes moyens de commutation (22, 27) qui, à l'état fermé et lorsque les seconds moyens de commutation (12, 17) sont à l'état fermé, appliquent en sortie du comparateur (1) le signal issu de la quatrième source (S2⁻), à la suite de la détection d'un desdits événements dans le second des signaux de référence et provenant de l'oscillateur, le signal de sortie (I_{O}) du comparateur ayant un niveau correspondant à la somme des signaux de commande appliqués par les moyens de commutation en sortie du comparateur, et
- des seconds moyens de commande (23, 28) pour commander les premiers à quatrièmes moyens de commutation pour les placer à l'état ouvert lorsque les troisièmes et quatrièmes moyens de commutation sont simultanément à l'état fermé.

8. Comparateur de phase et de fréquence selon la revendication 7,
**caractérisé en ce que** le premier et le second niveau (Iₙ, Iₙ+ε) des signaux de commande sont constants.

9. Comparateur de phase et de fréquence selon la revendication 7 ou 8,
**caractérisé en ce que** le second niveau de signal de commande est légèrement supérieur au premier niveau de signal de commande.

10. Comparateur de phase et de fréquence selon l'une des revendications 7 à 9,
**caractérisé en ce que** le signal issu de l'oscillateur (2) appliqué en entrée du comparateur (1) est obtenu en divisant par un rapport de division (N) la fréquence (F_{VCO}) du signal de sortie de l'oscillateur (2).

11. Comparateur de phase et de fréquence selon l'une des revendications 7 à 10,
**caractérisé en ce qu'**il comprend en outre des seconds moyens de détection (21, 22) pour détecter en permanence dans chacun des signaux de référence (S_{ref}) et provenant de l'oscillateur des événements représentatifs de la fréquence et de la phase du signal, et des moyens (24, 25) pour activer les seconds moyens de détection uniquement lorsque les premiers ou les seconds moyens de commutation (11, 16 ; 12, 17) sont à l'état fermé, et pour maintenir les seconds moyens de détection à l'état fermé indépendamment de l'état des premiers moyens de détection.

12. Comparateur de phase et de fréquence selon la revendication 11,
**caractérisé en ce qu'**il comprend en outre des moyens (31, 32) pour maintenir actifs les seconds moyens de détection (21, 22) pendant le passage à l'état ouvert des premiers et seconds moyens de commutation (11, 16, 12, 17).

13. Comparateur de phase et de fréquence selon l'une des revendications 7 à 12,
**caractérisé en ce qu'**il comprend en outre des moyens (35, 36, 37) pour maintenir les premiers (13, 28) et seconds (23, 35) moyens de commande à l'état actif tant que les premiers (11, 16) et seconds (12, 17) et/ou les troisièmes (21, 26) et quatrièmes (22, 27) moyens de commutation ne sont pas passés à l'état ouvert, à la suite du déclenchement des moyens de commande.

14. Comparateur de phase et de fréquence selon l'une des revendications 7 à 13,
**caractérisé en ce qu'**il comprend en outre :
- une (2i-1)-ième source de signal de commande d'un i-ième niveau,
- une (2i)-ième source de signal de commande ayant le i-ième niveau et de polarité opposée au signal issu de la (2i-1)-ième source,
- des (2i-1)-ième moyens de commutation qui, à l'état fermé et lorsque les (2i-3)-ième moyens de commutation sont à l'état fermé, appliquent en sortie du comparateur (1) le signal de commande issu de la (2i-1)-ième source, à la suite de la détection d'un desdits événements dans le premier des signaux de référence et provenant de l'oscillateur,
- des (2i)-ième moyens de commutation qui, à l'état fermé et lorsque les (2i-2)-ième moyens de commutation sont à l'état fermé, appliquent en sortie du comparateur (1) le signal issu de la (2i)-ième source, à la suite de la détection d'un desdits événements dans le second des signaux de référence et provenant de l'oscillateur, le signal de sortie (I_{O}) du comparateur ayant un niveau correspondant à la somme des signaux de commande appliqués par les moyens de commutation en sortie du comparateur, et
- des moyens pour commander les (2i-3)-ième à (2i)-ième moyens de commutation pour les placer à l'état ouvert lorsque les (2i-1)-ième et (2i)-ième moyens de commutation sont simultanément à l'état fermé.

## Claims

1. A method for controlling, as a function of frequency (F_{ref}) and phase of a reference signal (S_{ref}), the frequency (F_{vco}) and phase of an output signal of an oscillator (2) having a frequency control input, said method comprising the steps of:
- detecting continuously in the reference signal (S_{ref}) and in the signal from the oscillator events representative of the frequency and the phase of that signal,
- generating a first control signal at a first level (Iₙ) after detecting one of said events in a first signal of said reference signal and said signal from the oscillator,
- generating a second control signal at the first level after detecting one of said events in the second signal of said reference signal and said signal from the oscillator,
- applying the control signal (Iₒ; Vₒ) thus generated to the control input of the oscillator, and
- halting generation of the first and second control signals if they are generated simultaneously,
which method is **characterized in that** the first and second control signals are of opposite polarity, said method further comprising the steps of:
- triggering the generation of a third control signal at a second level (In + ε) after detecting one of said events in said first signal of said reference signal (S_{ref}) and said signal from the oscillator (2), if the first control signal is generated,
- triggering the generation of a fourth control signal at the second level and of the opposite polarity to the third control signal after detecting one of said events in said second signal of the reference signal and the signal from the oscillator, if the second control signal is generated,
- determining the control signal (Iₒ; Vₒ) to be applied to the control input of the oscillator (2) by adding all of the control signals thus generated, and
- halting generation of all the control signals if the third and fourth control signals are generated simultaneously.

2. A method according to claim 1, **characterized in that** the frequency (F_{vco}) of the output signal of the oscillator (2) is divided by a division ratio (N) and events in the signal from the oscillator are detected in the signal whose frequency (F_{vco}) has been divided by the division ratio (N).

3. A method according to either claim 1 or claim 2, **characterized in that** the second control signal level (Iₙ + ε) is identical to the first control signal level (Iₙ).

4. A method according to either claim 1 or claim 2, **characterized in that** the second control signal level (Iₙ + ε) is slightly higher than the first control signal level (Iₙ).

5. A method according to any one of claims 1 to 4, **characterized in that** it further comprises the steps of:
- generating a (2i-1)^{th} control signal at an i^{th} level after detecting one of said events in the first signal of said reference signal and said signal from the oscillator (2) while the (2i-3)^{th} control signal is generated, where i is an integer greater than 2,
- generating a (2i)^{th} control signal at the i^{th} level and of the opposite polarity to the (2i-1)^{th} control signal after detecting one of said events in the first signal of said reference signal and said signal from the oscillator while the (2i-2)^{th} control signal is generated, and
- halting the generation of the (2i)^{th}, (2i-1)^{th}, (2i-2)^{th} and (2i-3)^{th} control signals if the (2i)^{th}, (2i-1)^{th} control signals are generated simultaneously.

6. A method according to claim 5, **characterized in that** the i^{th} control signal level is identical to the (i-1)^{th} control signal level.

7. A phase and frequency comparator adapted to control the frequency of the output signal of an oscillator (2) having a frequency control input, the comparator receiving at its input a signal (S_{ref}) having a reference frequency (F_{ref}) and a signal from the oscillator and comprising:
- first detection means (11, 12) for detecting continuously in the reference signal (S_{ref}) and in the signal from the oscillator events representative of the frequency and the phase of the signal,
- a first source (S1⁺) of control signals at a first level (Iₙ),
- a second source (S1⁻) of control signals at the first level (Iₙ) and of the opposite polarity to the signal from the first source,
- first switching means (11, 16) which when closed apply to the output of the comparator (1) the control signal from the first source (S1⁺) after detection of one of said events in a first signal of said reference signal and said signal from the oscillator,
- second switching means (12, 17) which when closed apply to the output of the comparator (1) the signal from the second source (S1⁻) after detection of one of said events in the second signal of said reference signal and said signal from the oscillator, and
- first control means (13) for controlling the first and second switching means to place them in the open state when they are simultaneously in the closed state,
which phase comparator is **characterized in that** it further comprises:
- a third source (S2⁺) of control signals at a second level (Iₙ + ε),
- a fourth source (S2⁻) of control signals at the second level (Iₙ + ε) and of the opposite polarity to the signal from the third source,
- third switching means (21, 26) which, in the closed state when the first switching means (11, 16) are in the closed state, apply to the output of the comparator (1) the control signal from the third source (S2⁺) after detection of one of said events in the first signal of said reference signal and said signal from the oscillator,
- fourth switching means (22, 27) which, in the closed state when the second switching means (12, 17) are in the closed state, apply to the output of the comparator (1) the signal from the fourth source (S2⁻) after detection of one of said events in the second signal of said reference signal and said signal from the oscillator, the output signal (Iₒ) of the comparator having a level corresponding to the sum of the control signals applied by the switching means to the output of the comparator, and
- second control means (23, 28) for controlling the first to fourth switching means to place them in the open state when the third and fourth switching means are simultaneously in the closed state.

8. A phase and frequency comparator according to claim 7, **characterized in that** the first and second control signal levels (Iₙ, (Iₙ + ε)) are constant.

9. A phase and frequency comparator according to claim 7 or claim 8, **characterized in that** the second control signal level is slightly higher than the first control signal level.

10. A phase and frequency comparator according to any one of claims 7 to 9, **characterized in that** the signal from the oscillator (2) applied to the input of the comparator (1) is obtained by dividing the frequency (F_{VCO}) of the output signal of the oscillator (2) by a division ratio (N).

11. A phase and frequency comparator according to any one of claims 7 to 10, **characterized in that** it further comprises second detector means (21, 22) for continuously detecting in the reference signal (S_{ref}) and in the signal from the oscillator events representative of the frequency and the phase of that signal and means (24, 25) for activating the second detection means only if the first or the second switching means (11, 16; 12, 17) are in the closed state and for maintaining the second detection means in the closed state independently of the state of the first detection means.

12. A phase and frequency comparator according to claim 11, **characterized in that** it further comprises means (31, 32) for maintaining the second detection means (21, 22) active during the change to the open state of the first and second switching means (11, 16, 12, 17).

13. A phase and frequency comparator according to any one of claims 7 to 12, **characterized in that** it further comprises means (35, 36, 37) for maintaining the first control means (13, 28) and the second control means (23, 35) in the active state unless the first switching means (11, 16) and the second switching means (12, 17) and/or the third switching means (21, 26) and the fourth switching means (22, 27) have changed to the open state after triggering of the control means.

14. A phase and frequency comparator according to any one of claims 7 to 13, **characterized in that** it further comprises:
- a (2i-1)^{th} source of control signals at an i^{th} level,
- a (2i)^{th} source of control signals at the i^{th} level and of the opposite polarity to the signal from the (2i-1)^{th} source,
- (2i-1)^{th} switching means which, in the closed state when the (2i-3)^{th} switching means are in the closed state, apply to the output of the comparator (1) the control signal from the (2i-1)^{th} source after detection of one of said events in the first signal of said reference signal and said signal from the oscillator,
- (2i)^{th} switching means which, in the closed state when the (2i-2)^{th} switching means are in the closed state, apply to the output of the comparator (1) the signal from the (2i)^{th} source, after detection of one of said events in the second signal of said reference signal and said signal from the oscillator, the output signal (Iₒ) of the comparator having a level corresponding to the sum of the control signals applied by the switching means to the output of the comparator, and
- means for controlling the (2i-3)^{th} to (2i)^{th} switching means to place them in the open state when the (2i-1)^{th} and (2i)^{th} switching means are simultaneously in the closed state.

## Patentansprüche

1. Verfahren zu dem von der Frequenz (F_{ref}) und der Phase eines Referenzsignals (S_{ref}) abhängigen Anlegen der Frequenz und Phase (F_{VCO}) des Ausgangssignals eines mit einem frequenzgesteuerten Eingang ausgerüsteten Oszillators (2), wobei dieses Verfahren besteht aus:
- permanentes Erfassen in jedem der aus dem Oszillator stammenden Referenzsignale (S_{ref}) von für die Frequenz und die Phase des Signals repräsentativen Ereignissen,
- Erzeugen eines ersten Steuersignals mit einem ersten Pegel (Iₙ), nach der Erfassung eines der besagten Ereignisse in einem ersten der aus dem Oszillator kommenden Referenzsignale,
- Erzeugen eines zweiten Steuersignals auf dem ersten Pegel mit einer dem ersten Steuersignal entgegengesetzten Polarität, nach der Erfassung eines der besagten, aus dem Oszillator kommenden Ereignisse in dem zweiten der Referenzsignale,
- Anlegen des am Steuereingang des Oszillators erzeugten Steuersignals (Iₒ, Vₒ), und
- Anhalten der Erzeugung des ersten und zweiten Steuersignals, wenn sie gleichzeitig erzeugt werden,
**dadurch gekennzeichnet, dass** das erste und zweite Steuersignal eine entgegengesetzte Polarität aufweisen, wobei das Verfahren ferner die Schritte aufweist, die bestehen aus:
- Auslösen der Erzeugung eines dritten Steuersignals mit einem zweiten Pegel (Iₙ + ∈) nach der Erfassung der besagten, aus dem Oszillator (2) kommenden Ereignisse im ersten der Referenzsignale (S_{ref}), wenn das erste Steuersignal erzeugt ist,
- Auslösen der Erzeugung eines vierten Steuersignals mit dem zweiten Pegel mit einer dem dritten Steuersignal entgegengesetzten Polarität, nach der Erfassung eines der besagten Ereignisse im zweiten der aus dem Oszillator kommenden Referenzsignale, wenn das zweite Signal erzeugt ist,
- Bestimmen des an den Steuereingang des Oszillators (2) anzulegenden Steuersignals (Io, Vo), indem alle erzeugten Steuersignale aufaddiert werden, und Anhalten der Erzeugung aller Steuersignale, wenn das dritte und vierte Steuersignal gleichzeitig erzeugt werden.

2. Verfahren nach Anspruch 1, **dadurch gekennzeichnet dass** die Frequenz (F_{vco}) des Ausgangssignals des Oszillators (2) durch ein Teilungsverhältnis (N) geteilt wird, wobei die Erfassung der Ereignisse in dem aus dem Oszillator kommenden Signal in dem Signal ausgeführt wird, dessen Frequenz (F_{vco}) durch das Teilungsverhältnis (N) geteilt ist.

3. Verfahren nach Anspruch 1 oder 2, **dadurch gekennzeichnet dass** der zweite Pegel (Iₙ + ε) des Steuersignals mit dem ersten Pegel (Iₙ) des Steuersignals identisch ist.

4. Verfahren nach Anspruch 1 oder 2, **dadurch gekennzeichnet dass** der zweite Pegel (Iₙ + ε) des Steuersignals etwas größer als der erste Pegel (Iₙ) des Steuersignals ist.

5. Verfahren nach einem der Ansprüche 1 bis 4, **dadurch gekennzeichnet, dass** es außerdem Schritte umfasst, die folgendes aufweisen:
- Erzeugung, nach der Erfassung eines der besagten aus dem Oszillator (2) kommenden Ereignisse in dem ersten der Referenzsignale, eines (2i-1)-ten Steuersignals mit einem i-ten Pegel, während das (2i-3)-te Steuersignal erzeugt wird, wobei i eine ganze über 2 liegende Zahl ist,
- Erzeugung, nach der Erfassung eines der besagten aus dem Oszillator kommenden Ereignisse in dem ersten der Referenzsignale, eines (2i)-ten Steuersignals mit einem i-ten Pegel und mit einer dem (2i-1)- ten Steuersignal entgegengesetzten Polarität, während das (2i-2)-te Steuersignal erzeugt wird,
- Anhalten der Erzeugung des 2i-ten, (2i-1)-ten, (2i - 2)-ten und (2i - 3)-ten Steuersignals wenn die (2i)-ten und (2i -1)-ten Steuersignale gleichzeitig erzeugt werden.

6. Verfahren nach Anspruch 5, **dadurch gekennzeichnet, dass** der i-te Pegel des Steuersignals mit dem (i - 1)-ten Pegel des Steuersignals identisch ist.

7. Mit einem Frequenzsteuerungseingang ausgerüsteter Phasen- und Frequenzkomparator zur Steuerung der Frequenz des Ausgangssignals eines Oszillators (2), wobei der Komparator am Eingang ein Signal (S_{ref}), das eine Referenzfrequenz (F_{ref}) hat und ein aus dem Oszillator kommendes Signal empfängt und folgendes umfasst:
- erste Erfassungsmittel (11, 12), um fortdauernd in jedem der aus dem Oszillator kommenden Referenzsignale (S_{ref}) für die Frequenz und die Phase des Signals repräsentative Ereignisse zu erfassen,
- eine erste Quelle (S1⁻) für das Steuersignal mit einem ersten Pegel (Iₙ),
- eine zweite Quelle (S1⁻) für das Steuersignal, das den ersten Pegel hat und eine Polarität aufweist, die der des aus der ersten Quelle kommenden Signals entgegengesetzt ist,
- erste Schaltmittel (11, 16), die nach der Erfassung eines der besagten Ereignisse in einem ersten der aus dem Oszillator kommenden Referenzsignale, das aus der ersten Quelle (S1⁺) kommende Steuersignal im geschlossenen Zustand am Ausgang des Komparators (1) anlegen,
- zweite Schaltmittel (12, 17), die nach der Erfassung eines der besagten Ereignisse in dem zweiten der aus dem Oszillator kommenden Referenzsignale, das aus der ersten Quelle (S1⁻) kommende Steuersignal im geschlossenen Zustand am Ausgang des Komparators (1) anlegen,
- erste Steuermittel (13), um die ersten und zweiten Schaltmittel zu steuern, um sie in einen geöffneten Zustand zu überführen, wenn sie gleichzeitig im geschlossenen Zustand sind,
**dadurch gekennzeichnet, dass** der besagte Komparator außerdem folgendes umfasst:
- eine dritte Quelle (S2⁺) des Steuersignals mit einem zweiten Pegel (Iₙ + ε),
- eine vierte Quelle (S2⁻) des Steuersignals, das den zweiten Pegel (Iₙ + ε) und eine dem aus der dritten Quelle kommenden Signal entgegengesetzte Polarität hat,
- dritte Schaltmittel (21, 26), die nach der Erfassung eines der besagten Ereignisse in dem ersten der aus dem Oszillator kommenden Referenzsignale, in geschlossenem Zustand und wenn die ersten Schaltmittel (11, 16) in geschlossenem Zustand sind, das aus der dritten Quelle (S2⁺) kommende Steuersignal am Ausgang des Komparators (1) anlegen,
- vierte Schaltmittel (22, 27), die nach der Erfassung eines der besagten Ereignisse in dem zweiten der aus dem Oszillator kommenden Referenzsignale, in geschlossenem Zustand und wenn die zweiten Schaltmittel (12, 17) in geschlossenem Zustand sind, das aus der vierten Quelle (S2⁻) kommende Steuersignal am Ausgang des Komparators (1) anlegen, wobei das Ausgangssignal (Iₒ) des Komparators einen Pegel hat, der der Summe der durch die Schaltmittel am Ausgang des Komparators angelegten Steuersignale entspricht, und
- zweite Steuermittel (23, 28) um die ersten bis vierten Schaltmittel zu steuern, um sie in den geöffneten Zustand zu überführen, wenn die dritten und vierten Schaltmittel sich gleichzeitig im geschlossenen Zustand befinden.

8. Phasen- und Frequenzkomparator nach Anspruch 7, **dadurch gekennzeichnet dass** der erste und zweite Pegel (Iₙ, Iₙ + ε) der Steuersignale konstant sind.

9. Phasen- und Frequenzkomparator nach Anspruch 7 oder 8, **dadurch gekennzeichnet dass** der zweite Pegel des Steuersignals etwas grösser als der erste Pegel des Steuersignals ist.

10. Phasen - und Frequenzkomparator nach einem der Ansprüche 7 bis 9, **dadurch gekennzeichnet, dass** das aus dem Oszillator (2) kommende, am Eingang des Komparators (1) beaufschlagte Steuersignal erhalten wird, indem die Frequenz (F_{VCO}) des Ausgangssignals des Oszillators (2) durch ein Teilungsverhältnis (N) geteilt wird.

11. Phasen - und Frequenzkomparator nach einem der Ansprüche 7 bis 10, **dadurch gekennzeichnet, dass** er außerdem zweite Erfassungsmittel (21, 22) umfasst, um permanent in jedem der aus dem Oszillator kommenden Referenzsignale (S_{ref}) Ereignisse zu erfassen, die für die Frequenz und die Phase des Signals repräsentativ sind, und Mittel (24, 25) umfasst, um die zweiten Erfassungsmittel nur zu aktivieren, wenn die ersten und zweiten Schaltmittel (11, 16; 12, 17) im geschlossenen Zustand sind, und um die zweiten Erfassungsmittel unabhängig vom Zustand der ersten Erfassungsmittel im geschlossenen Zustand zu halten.

12. Phasen - und Frequenzkomparator nach Anspruch 11, **dadurch gekennzeichnet, dass** er außerdem Mittel (31, 32) umfasst, die die zweiten Erfassungsmittel (21, 22) während des Übergangs in den geöffneten Zustand der ersten und zweiten Schaltmittel (11, 16, 12, 17) in aktivem Zustand halten.

13. Phasen - und Frequenzkomparator nach einem der Ansprüche 7 bis 12, **dadurch gekennzeichnet, dass** er außerdem Mittel (35, 36, 37) umfasst, um die ersten (13, 28) und zweiten (23, 35) Steuermittel im aktiven Zustand zu halten, solange die ersten (11, 16) und zweiten (12, 17) und oder dritten (21, 26) und / oder vierten (22, 27) Schaltmittel nach dem Auslösen der Steuermittel nicht in den geöffneten Zustand übergegangen sind.

14. Phasen - und Frequenzkomparator nach einem der Ansprüche 7 bis 13, **dadurch gekennzeichnet, dass** er außerdem folgendes umfasst:
- eine (2i - 1)-te Steuersignalquelle mit einem i-ten Pegel,
- eine (2i) - te Steuersignalquelle, die einen i-ten Pegel und eine Polarität hat, die der des aus der (2i -1) ten Quelle kommenden Signal entgegengesetzt ist,
- (2i-1) - te Schaltmittel, die nach der Erfassung eines der besagten Ereignisse in dem ersten der aus dem Oszillator kommenden Referenzsignale in geschlossenem Zustand und wenn die (2i-3) ten Schaltmittel in geschlossenem Zustand sind, am Ausgang des Komparators (1) das aus der (2i -1) ten Quelle kommende Steuersignal anlegen,
- (2i) - te Schaltmittel, die nach der Erfassung eines der besagten Ereignisse in dem zweiten der aus dem Oszillator kommenden Referenzsignale in geschlossenem Zustand und wenn die (2i-2) ten Schaltmittel in geschlossenem Zustand sind, am Ausgang des Komparators (1) das aus der (2i) ten Quelle kommende Steuersignal anlegen, wobei das Ausgangssignal (Iₒ) des Komparators einen Pegel hat, der der Summe der Steuersignale entspricht, die durch die Schaltmittel am Ausgang des Komparators angelegt werden, und
- Mittel zur Steuerung der (2i-3) - ten bis (2i) - ten Schaltmittel, um sie in den geöffneten Zustand überzuführen, wenn die (2i-1) - ten bis (2i) - ten Schaltmittel sich gleichzeitig im geschlossenen Zustand befinden.
